# EUROPÄISCHE PATENTSCHRIFT

(11) **EP 0 453 488 B1**
(45) Veröffentlichungstag und Bekanntmachung des Hinweises auf die Patenterteilung: **05.04.1995**
(21) Anmeldenummer: 90902190.9
(22) Anmeldetag: 12.01.1990
(51) Int. Cl.: G03F 7/095, G03F 7/038, B05D 1/20, C08L 33/16

(54) **STRAHLENEMPFINDLICHER FILM AUS MINDESTENS EINER MONOMOLEKULAREN SCHICHT VON FLUORHALTIGEN AMPHIPHILEN**
RADIATION-SENSITIVE FILM COMPRISING AT LEAST ONE MONOMOLECULAR LAYER OF FLUORINE-CONTAINING AMPHIPHILIC SUBSTANCES
FILM SENSIBLE AUX RAYONNEMENTS COMPOSE D'AU MOINS UNE COUCHE MONOMOLECULAIRE EN AMPHIPHILES FLUORES

(30) Priorität: 14.01.1989 DE 3901003
(43) Veröffentlichungstag der Anmeldung: 30.10.1991
(73) Patentinhaber: HOECHST AKTIENGESELLSCHAFT, 65926 Frankfurt am Main (DE)
(72) Erfinder: ERDELEN, Christian, D-6200 Wiesbaden (DE); RINGSDORF, Helmut, D-6500 Mainz (DE); PRASS, Werner, D-6500 Mainz (DE); SCHEUNEMANN, Ude, D-6237 Liederbach (DE)
(86) Internationale Anmeldenummer: EP9000069
(87) Internationale Veröffentlichungsnummer: WO9008346

(56) Entgegenhaltungen:
- EP-A- 0 069 978
- FR-A- 2 584 083
- US-A- 3 910 187
- JEE JOURNAL OF ELECTRONIC ENGINEERING, vol. 22, no. 225, September 1985, TOKYO, JP, Seiten 32 - 36; T. KITAYAMA: "Lithographic Reproduction Technology Focuses on Submicron Chip Patterns"
- JOURNAL OF MOLECULAR ELECTRONICS, vol. 1, no. 1, July 1985, CHICESTER, GB, Seiten 1 - 17; M. SUGI: "Langmuir-Blodgett Films- a Course Towards Molecular Electronics"

## Beschreibung

Die Erfindung bezieht sich auf einen durch Strahlung härtbaren Film aus mindestens einer monomolekularen Schicht aus organischen Polymeren mit langkettigen, fluorhaltigen und Oxirane enthaltenden Seitenketten auf einem festen Schichtträger (= sogenannte Schichtelemente), auf ein Verfahren zur Herstellung der Schichtelemente und ihrer Härtung gegebenenfalls unter Strukturierung.

Zur Herstellung von geordneten Schichten organischer Polymerer mit langkettigen Seitengruppen wird überwiegend das Langmuir-Blodgett (LB)-Verfahren benutzt. Bei diesem Verfahren werden Moleküle auf einer Wasseroberfläche gespreitet und durch Verkleinerung der Fläche pro Molekül die langen Alkylseitengruppen parallel angeordnet. Bei konstantem Schub werden die Moleküle durch Ein- und Austauchen auf ein Substrat aufgezogen. Pro Tauchgang wird dabei eine monomolekulare Schicht unter Erhalt ihrer Ordnung übertragen.

Für den Aufbau von LB-Filmen verwendet man amphiphile Moleküle, d.h. Moleküle, die ein hydrophiles Ende (einen "Kopf") und eine hydrophobes Ende (einen "Schwanz") haben. Es gibt auch amphiphile Moleküle, bei denen als hydrophobe Einheiten perfluorierte Alkylketten dienen. Um eine höhere Stabilität der LB-Filme zu erreichen, wurden auch schon polymere LB-Filme, darunter auch solche mit langkettigen fluorhaltigen Seitenketten an einer Polymethacrylat- oder Polyacrylat-Basis hergestellt. Solche Filme sind in der nicht vorveröffentlichten deutschen Patentanmeldung P 37 31 606.0 beschrieben. Sie zeigen eine gute Ordnung und daraus resultierend eine geringe kritische Oberflächenspannung, die sie z.B. für Anwendungen zur Reibungsminderung interessant machen. Sie sind aber z.B. durch Lösungsmittel noch ablösbar und verlieren damit ihre Schutzwirkung. Auch eine Anwendung in der Mikrolithographie ist mit den dort beschriebenen Polymeren nicht möglich. Ein Überblick über die Verwendung von LB-Filmen in der Molekularelektronik wird im Journal of Molecular Electronics, 1/1985, July/Sept. No. 1 gegeben. Die Mikrostrukturierung von LB-Filmen mit Elektronenstrahlen ist schon in verschiedenen Beispielen beschrieben worden, darunter auch schon mit oxiranhaltigen Filmen, wie z.B. von B. Boothroyd, P.A. Delaney, R.A. Hann, R.W. Johnstone und A. Ledwith in Brit. Polym J. 17, 360-363 (1985). Dort wird die elektronenstrahlinduzierte Polymerisation von monomeren Oxiranhaltigen Amphiphilen in LB-Filmen beschrieben. Höhermolekulare Filme aus langkettigen Acryl- und Methacrylpolymeren mit Perfluoralkylgruppen und gegebenenfalls Oxiranresten in den Seitenketten, sowie deren Strukturierung sind aus der Literatur bekannt (EP-A-0 069 987); US-A-3 920 187; FR-A-2 584 083; JEE Journal of Electronic Eng., Vol. 22, No. 225 (9/85), Seiten 32-36). Eine Strukturierung durch Vernetzung von polymeren Oxiranen ist bisher in LB-Filmen noch nicht beschrieben worden.

Es bestand daher die Aufgabe, synthetisch einfach zugängliche, durch Oxiraneinheiten vernetzbare Polymere mit unpolaren Seitenketten herzustellen, die sich gut auf Schichtträger übertragen lassen.

Die vorliegende Erfindung löst diese Aufgabe. Sie beruht auf der Erkenntnis, daß die durch Copolymerisation von Vinylmonomeren, die langkettige Fluoralkylgruppen enthalten, mit oxirangruppenhaltigen Vinylmonomeren erhältlichen Produkte gute Filmbildner sind. Durch die fluorhaltigen Alkylketten wird eine hohe Ätzstabiltität und eine besonders geringe kritische Oberflächenspannung erreicht. Die Oxiran-Einheiten sind reaktionsfähig und sorgen für die Strukturierbarkeit. Sie sollten außerdem als polare Einheiten im Polymeren die Funktion von hydrophilen Spacern übernehmen, durch die, wie z.B. von A. Laschewsky, H. Ringsdorf, G. Schmidt und J. Schneider in J. Am. Chem. Soc. 109, 788-796 (1987) beschrieben, die unterschiedlichen Ordnungstendenzen von Polymerhauptkette (Tendenz zum Polymerknäuel) und Alkylseitenkette (Tendenz zur Kristallisation) und damit der Erhalt von geordneten Schichten ermöglicht werden.

Die erfindungsgemäße Copolymerisation verläuft besonders günstig in Lösung unter radikalischen Bedingungen, z. B. in Tetrahydrofuran als Lösungsmittel bei 64°C mit 1 % Azo-bis-isobutyronitril als Radikalstarter und bei Monomerverhältnissen von 1 Mol fluoralkylhaltigem zu 0,05 bis 10 Mol oxiranhaltigem Monomeren.

Der erfindungsgemäße Film besteht aus mindestens einer monomolekularen Schicht, welche ein organisches Polymeres mit langkettigen fluorierten Alkylseitengruppen und Oxiraneinheiten enthält oder aus diesem besteht. Als Alkylseitengruppen kommen in Frage solche der Formel I:

CF₃- (CF₂)ₙ- (CH₂)ₘ- (I)

worin n eine Zahl von null bis 23 und m eine Zahl von null bis 24 bedeutet. Verbindungen, in denen n = 5 bis 11 und m = 13 bis 23 ist, sind besonders leicht zugänglich. Verbindungen, in denen n + m = 8 bis 24 ist, zeigen besonders günstige amphiphile Eigenschaften.

Die Polymeren sind amphiphil und enthalten als polare Gruppe ("hydrophile Kopfgruppe") vorzugsweise mindestens eine der Gruppen 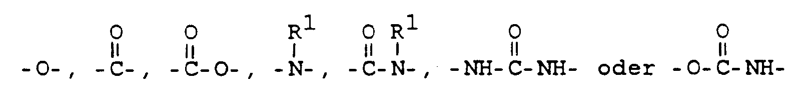
wobei R¹ = H oder eine verzweigte oder unverzweigte Alkylkette mit 1-24, vorzugsweise 1-10 C-Atomen ist, die gegebenenfalls noch durch polare Gruppen substituiert sein kann.

Die Oxiraneinheiten werden bevorzugt als Comonomere in das Polymere eingebaut. Besonders bevorzugt sind Comonomere der Formel II, 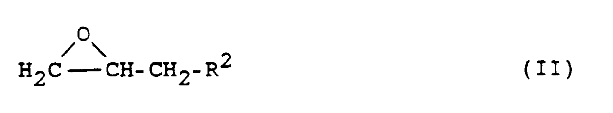
wobei R² ein vinylgruppenhaltiger Rest , z.B.

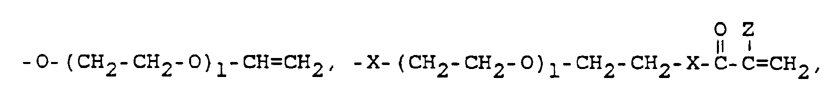

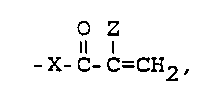

-C₆H₄-CH=CH₂

ist. 1 ist eine Zahl zwischen null und 10, X ist -O- oder -NH-.
Z kann sein:
-H, -(CH₂)₁-CH₃, -CF₃, -Cl, -F oder -CN.

In dem Comonomeren kann auch mehr als ein Oxiranring vorhanden sein, wie im folgenden Beispiel gezeigt 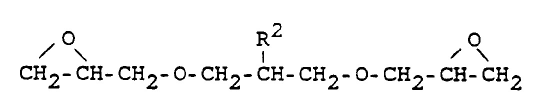
wobei R² die oben genannte Bedeutung hat.

Die Haftung der einzelnen Monolagen untereinander kann, wie in der unveröffentlichten europäischen Patentanmeldung 88 111 577.8 beschrieben, durch eine alternierende Abfolge von Monofilmen mit fluorierten und nicht fluorierten Alkylketten erhöht werden. Dazu müssen an den hydrophoben Enden im Schichtsystem den -CF₃-Gruppen immer -CH₃-Gruppen gegenüberstehen, deren partielle Dipolmomente molekülbezogen entgegengesetzt sind. Um dies zu erreichen, kann man zum einen Schichtsysteme mit alternierender Schichtfolge A-B-A-B, zum andern auch Schichtsysteme mit alternierenden Doppelschichten A-A-B-B-A-A-B-B herstellen, wobei A und B Schichten mit fluorierten und nicht fluorierten Alkylgruppen an den hydrophoben Enden bedeuten.

Zur Herstellung einer Schicht A werden die erfindungsgemäßen organischen Polymeren oder Mischungen, die daneben noch eine zweite niedermolekulare oder hochmolekulare amphiphile Verbindung in Mengen von bis zu 99 Gew.-%, vorzugsweise in Mengen von 10 - 99 Gew.-% enthalten, in einem im wesentlichen flüchtigen, mit Wasser nicht mischbaren Lösungsmittel gelöst und auf die Oberfläche einer wäßrigen Lösung in einer Filmwaage gebracht (=gespreitet). Zur Herstellung einer Schicht B wird eine zweite niedermolekulare oder hochmolekulare amphiphile Verbindung, die frei ist von Fluoralkylgruppen, analog gelöst und gespreitet.

Der hydrophobe Teil der zweiten amphiphilen Verbindung soll eine gewisse Mindestlänge aufweisen. Es ist bevorzugt, wenn die zweite amphiphile Verbindung mindestens einen hydrophoben Teil, in dem mindestens 8 Kohlenstoffatome enthalten sind, und mindestens eine der folgenden polaren Gruppen: Äther-, Hydroxy-, Carbonsäure-, Carbonsäureester-, Amin-, Carbonsäureamid-, Ammoniumsalz-, Sulfat-, Sulfonsäure-, Phosphorsäure-, Phosphonsäure-, Phosphonsäureester-, Phosphonsäureamid-, Phosphorsäureester- oder Phosphorsäureamid-Gruppe enthält.

Besonders bevorzugt ist es, wenn die amphiphile Verbindung aus mindestens einem hydrophoben Teil mit mindestens 8 Kohlenstoff-Atomen und mindestens einem polaren Teil besteht, der ausgewählt ist aus den folgenden Gruppen

-OR⁵

- COOR³

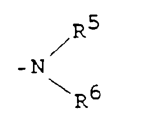

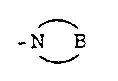

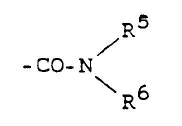

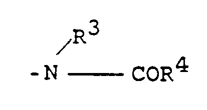

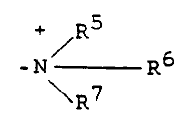

-SO₃H

-OSO₃R³

-OPO(OR³)(OR⁴)

-E

-O-E

-NR³-E,

wobei R³ bis R⁷, B und E folgendes bedeuten:
- R³ und R⁴: unabhängig voneinander H oder C₁-C₃-Alkyl,
- R⁵, R⁶ und R⁷: unabhängig voneinander H, C₁-C₄-Alkyl, -C₂H₄OH oder -CH₂-CHOH-CH₃, insbesondere H oder CH₃
- B: einen zweiwertigen organischen Rest, so daß -N B einen stickstoffhaltigen Heterocyclus, insbesondere einen 5- oder 6-gliedrigen, gesättigten oder ungesättigten Heterocyclus mit 1 bis 3 C-Atomen oder N- und O-Atomen oder N- und S-Atomen bildet, und
- E: 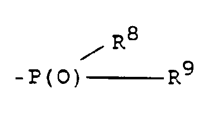 oder 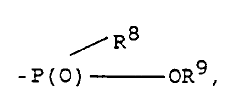 wobei R⁸ und R⁹ unabhängig voneinander für 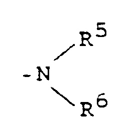 stehen.

Beispielsweise kann die amphiphile Verbindung eine Fettsäure der allgemeinen Formel CH₃(CH₂)_{g}CO₂H sein,
wobei g eine Zahl von 8 bis 25, vorzugsweise 12 bis 22, bedeutet.

Vorteilhafterweise wird als zweite amphiphile Verbindung ein ungesättigtes Säureamid der allgemeinen Formel III 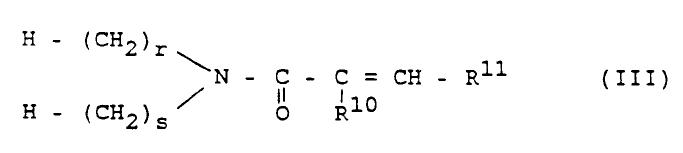
eingesetzt, in der
R¹⁰ H, Cl, F, CN oder (CH₂)ₜH,
R¹¹ H, (CH₂)ᵤH oder -CH=CH-(CH₂)ᵤH, r und s unabhängig voneinander eine Zahl von 0 - 22 und
t und u unabhängig voneinander eine Zahl von 0 - 24
insbesondere 0-18, bedeuten.
r ist vorzugsweise eine Zahl von null bis 18 und s ist vorzugsweise null.

Besonders bevorzugt als zweite amphiphile Verbindung wird ein Polymeres eingesetzt, das z. B. durch Copolymerisation eines langkettig substituierten ungesättigten Momoneren, z. B. der Formel IV 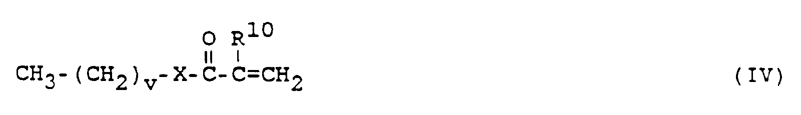
worin X = -O-, -NH-
und 9 ≦ v ≦ 24
und R¹⁰ die oben angegebene Bedeutung hat,
oder eines Amids nach Formel III (mit r > 0 und s > 0) mit einem polaren ungesättigten Monomeren (insbesondere ohne Alkylgruppe mit 11 oder mehr C-Atomen), z. B. der Formel V 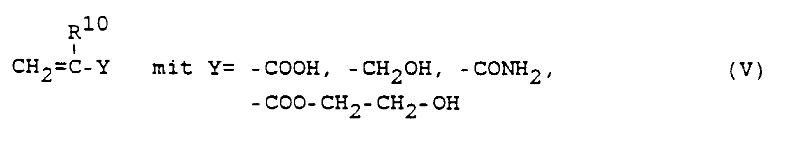
oder einem oxiranhaltigen Monomeren nach Formel II hergestellt werden kann.

Üblicherweise erfolgt die Herstellung der Filme und der monomolekularen Schichten mittels LB-Technik auf Wasseroberflächen. Daher ist es bevorzugt, wenn die amphiphile Verbindung nur eine geringe Wasserlöslichkeit, insbesondere eine Wasserlöslichkeit von weniger als 5 g/l bei 20°C aufweist.

Um eine ausreichend geringe Wasserlöslichkeit dieser amphiphilen Verbindung zu erzielen, ist es bevorzugt, daß mindestens einer der Werte für r, s, t und u mindestens 10 beträgt. Es ist jedoch nicht nötig, daß sämtliche Werte mindestens 10 betragen. Eine besonders bevorzugte Möglichkeit besteht darin, daß einer der Werte für t und u mindestens 10 und der andere Wert maximal 1 beträgt. Eine andere besonders bevorzugte Möglichkeit besteht darin, daß der Wert für r mindestens 10 beträgt und die Werte für t und u maximal 1 betragen.

Es ist auch möglich als amphiphile Verbindung gesättigte Säureamide der allgemeinen Formel VI 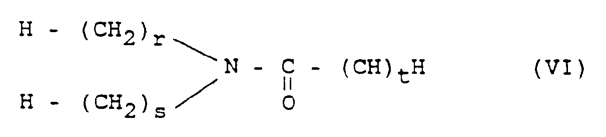
einzusetzen, wobei r und s unabhängig voneinander eine Zahl von 0 - 22 und t eine Zahl von 0 - 24 bedeutet, und mindestens einer der Werte für r, s und t mindestens 8 beträgt.

Auch hier ist es zur Erzielung einer ausreichenden Hydrophobie sinnvoll, daß mindestens einer der Werte für r, s und t mindestens 10 beträgt. Eine besonders bevorzugte Möglichkeit besteht darin, daß die Werte für r und s maximal 1 und der Wert für t mindestens 10 betragen. Eine andere besonders bevorzugte Möglichkeit besteht darin, daß der Wert für r mindestens 10 und der Wert für t maximal 1 beträgt.

Es ist günstig, wenn die Kettenlänge des eingesetzten Fluoralkyl-Oxiran-Polymeren und der zweiten amphiphilen Verbindung aufeinander abgestimmt werden. Es ist daher bevorzugt, daß die Länge der Alkykette des eingesetzten Fluoralkyl-Oxiran-Polymeren und des hydrophoben Teils der zweiten amphiphilen Verbindung sich um maximal 1 nm unterscheiden. Falls die zweite amphiphile Verbindung zwei oder mehr hydrophobe Teile aufweisen sollte, so ist der längste hydrophobe Teil maßgebend.

Die Moleküle werden bei der beschriebenen Technik der Filmherstellung mit einer Barriere zusammengeschoben, wobei die Alkylketten bei wachsender Oberflächendichte im wesentlichen senkrecht zur Grenzschicht orientiert werden. Während der Kompression entsteht durch Selbstorganisation der Moleküle an der Grenzschicht ein hochgeordneter monomolekularer Film, dessen konstante Schichtdicke im wesentlichen durch die Kettenlänge der Alkylseitenketten der Polymeren und deren Tiltwinkel (das ist der Winkel, um den die Molekülketten auf der Wasseroberfläche gegen die Normale gekippt sind) bestimmt wird. Die typische Dicke eines solchen Films liegt bei 2 - 3 nm.

Aus der Abmessung der Oberfläche, dem Spreitvolumen und der Konzentration der Lösung läßt sich die mittlere Fläche pro Repetiereinheit berechnen. Phasenübergänge bei der Kompression der Moleküle lassen sich in der Schubflächenisotherme verfolgen.

Der Film wird bei konstantem Schub durch Eintauchen oder Austauchen eines geeigneten Trägers unter Erhalt der Ordnung von der Wasseroberfläche abgenommen.

Als Subphase für die Monofilmherstellung dienen meist Wasser oder wäßrige Lösungen. Es sind aber auch andere Flüssigkeiten mit hoher Oberflächenspannung, wie z. B. Glyzerin, Glykol, Dimethylsulfoxid, Dimethylformamid oder Acetonitril verwendbar.

Als Träger kommen beliebige feste, vorzugsweise dimensionsstabile Substrate aus unterschiedlichen Materialien in Betracht. Die als Schichtträger dienenden Substrate können beispielsweise transparent oder lichtdurchlässig, elektrisch leitend oder isolierend sein. Das Substrat kann hydrophob oder hydrophil sein. Die Oberfläche des Substrats, auf die die LB-Schicht aufgebracht wird, kann hydrophobiert sein. Die zu beschichtende Oberfläche des Substrats sollte möglichst rein sein, damit die Ausbildung einer dünnen, geordneten Schicht nicht gestört wird. Insbesondere die Anwesenheit von oberflächenaktiven Stoffen auf der zu beschichtenden Oberfläche der Substrate kann die Schichtherstellung beeinträchtigen. Es ist möglich, die als Schichtträger dienenden Substrate auf der zu beschichtenden Oberfläche vor dem Aufbringen der LB-Filme zunächst mit einer Zwischenschicht zu versehen, um z.B. die Haftung des Films auf dem Substrat zu verbessern.

Als Materialien für die Substrate können beispielsweise Metalle, wie etwa Gold, Platin, Nickel, Palladium, Aluminium, Chrom, Niob, Tantal, Titan, Stahl und dergleichen verwendet werden. Andere geeignete Materialien für die Substrate sind Kunststoffe, wie beispielsweise Polyester, etwa Polyethylenterephthalat oder Polybutylenterephthalat, Polyvinylchlorid, Polyvinylidenchlorid, Polytetrafluorethylen, Polystyrol, Polyethylen oder Polypropylen.

Gleichermaßen kommen auch Halbleiter, wie Silizium, Germanium oder Galliumarsenid oder auch Glas, Siliziumdioxid, keramische Werkstoffe oder Celluloseprodukte für die Substrate in Betracht. Die Oberfläche von Glas und anderen hydrophilen Substraten kann, sofern erforderlich, in an sich bekannter Weise durch Umsetzung mit Alkylsilanen oder Hexamethyldisilazan hydrophobiert werden. Die Auswahl der Substratmaterialien richtet sich in erster Linie nach dem Verwendungszweck der aus dem erfindungsgemäßen Film hergestellten Schichtelemente. Für optische Elemente werden in der Regel transparente, lichtdurchlässige Substrate als Schichtträger eingesetzt. Werden die erfindungsgemäßen Schichtelemente beispielsweise in der Elektronik oder bei elektrochemischen Prozessen verwendet, dienen als Substrate insbesondere elektrisch leitfähige Materialien, wie Metalle oder metallische Oberflächenschichten, beispielsweise auf Kunststoffolien oder Glas.

Die als Träger für die erfindungsgemäßen Filme dienenden Substrate können, je nach Verwendungszweck, beliebige Formen aufweisen. Beispielsweise können sie film-, folien-, platten-, bandförmig oder auch zylinderförmig sein oder unter anderen beliebigen Formen ausgewählt werden. Im allgemeinen wird es sich bei den Schichtträgern um flache, ebene Substrate handeln, wie z.B. Filme, Folien, Platten, Bänder und dergleichen. Die zu beschichtende Oberfläche der Substrate ist vorzugsweise glatt, wie es für die Herstellung von LB-Filmen üblich ist. Bei flachen, ebenen Substraten können die erfindungsgemäßen Filme auf eine oder beide Oberflächen des Substrats aufgebracht werden.

Die erfindungsgemäßen Polymeren zeichnen sich durch eine gute Herstellbarkeit einer Multischichtstruktur mit wenigen Defektstellen aus, wobei die Schichtstruktur eine gute Temperaturstabiltät aufweist. Die Stabilität der Filme läßt sich durch eine Vernetzung der Polymerketten erhöhen. Diese Vernetzung kann z.B. durch die Einwirkung von UV-Licht, Elektronenstrahlen oder auch durch andere Arten von ionisierender Strahlung induziert werden. Die Vernetzungsreaktion kann auch ortsaufgelöst zur Schreiben kleiner Strukturen mit Hilfe eines Elektronenstrahlschreibgeräts erfolgen, wobei dem Fachmann Ausführungsformen mit und ohne Maske bekannt sind. Die vernetzten Stellen sind - im Gegensatz zu den unvernetzten - in polaren und unpolaren Lösungsmitteln unlöslich, so daß durch Anwendung von Lösungsmitteln ein strukturierter Film auf einem Träger erhalten werden kann.

Solche Filme auf Substraten eignen sich beispielsweise für optische Wellenleitersysteme oder zur Herstellung von Filtern für optische Zwecke. Aufgrund der geringen kritischen Oberflächenspannung sind die Filme auch zur Verbesserung der Reibungseigenschaften von Materialien, zur Herstellung von Schutzschichten sowie für weitere einschlägige Anwendungen geeignet.

Die Erfindung wird durch die nachfolgenden Beispiele näher erläutert.

### Beispiel 1: Radikalische Copolymerisation von N-(Methacryloxy-ethyl)-carbaminsäure-1H,1H,2H,2H-perfluordodecylester mit Glycidylacrylat

2.00 g N-(Methacryloxyethyl)-carbaminsäure-1H,1H,2H,2H-perfluordodecylester und 1.78 g Glycidylacrylat werden in 20 ml Tetrahydrofuran gelöst und mit 4.6 mg Azo-bis-isobutyronitril versetzt. Die Lösung wird in einen Dreihalskolben mit Rückflußkühler (mit Gasableitungsrohr und Blasenzähler), Thermometer und Gaseinleitungsrohr gegeben und bei Raumtemperatur eine Stunde lang mit Stickstoff durchspült. Dann wird bis zum Rückfluß erhitzt (Innentemperatur: 65°C) und 8 Stunden unter Rückfluß gekocht. Dabei wird die Reaktionsmischung ständig mittels Magnetrührer gerührt und mit Stickstoff gespült. Das Polymere wird durch Eingießen der Reaktionslösung in Hexan ausgefällt und unter Kühlung mit Trockeneis abgesaugt. Man erhält 2.2 g einer weißen Masse, die in Hexan und Methanol unlöslich und in Mischungen aus FKW 113 mit Hexafluorisopropanol löslich ist. Aus der Elementaranalyse (43.3 % C, 4.0 % H, 29.4 % F und 1.0 % N) ergibt sich eine Copolymerzusammensetzung von 1 Teil N-(Methacryloxyethyl)-carbaminsäure-1H,1H,2H,2H-perfluordodecylester und 5 Teilen Glycidylacrylat.

### Beispiel 2: Schichtherstellung nach der Langmuir-Blodgett Methode

Ein Glas-Objektträger (76 mm x 26 mm) wird nach folgendem Verfahren gereinigt:
Das Glas wird eine Stunde lang in eine 60°C warme, frisch angesetzte Mischung aus vier Teilen konz. H₂SO₄ und einem Teil 30 %iger H₂O₂ gelegt, mit sauberem Wasser abgespült und 15 Minuten lang in einer Reinigungslösung (®Extran AP 11, Konzentration 2 - 4 g/l) bei 50°C ultrabeschallt. Danach wird wieder gründlich mit sauberem Wasser abgespült und in einem warmen Luftstrom getrocknet. Anschließend erfolgt zur Hydrophobierung eine Behandlung mit Hexamethyldisilazan-Dampf (10 Minuten bei 70°C).

Multischichten aus dem in Beispiel 1 hergestellten Polymeren werden nach dem Verfahren von Langmuir und Blodgett auf den Glasträger übertragen, indem in einer Langmuir-Filmwaage 0.2 cm³ einer Lösung von 5 mg des Polymeren in 10 cm³ einer Mischung aus 9 Teilen FWK 113 und 1 Teil Hexafluorisopropanol auf einer wäßrigen Subphase bei einer Subphasentemperatur von 30°C gespreitet werden. Durch Verkleinerung der monofilmbedeckten Wasseroberfläche wird der Schub auf 20 mN/m eingeregelt und bei diesem Wert konstant gehalten. Der Träger wird nun senkrecht von oben durch die Wasseroberfläche in die Filmwaage eingetaucht (Eintauchgeschwindigkeit: 20 mm/min) und nach einer kurzen Pause (10 sec.) am unteren Umkehrpunkt wieder herausgenommen (Austauchgeschwindigkeit: 10 mm/min) Sowohl beim Eintauchals auch beim Austauchvorgang wird dabei eine Monolage auf den Träger übertragen. Durch mehrfache Wiederholung des Tauchvorgangs nach jeweils einer Minute Wartezeit am oberen Umkehrpunkt werden insgesamt 10 Doppelschichten übertragen. Die Übertragungsverhältnisse liegen bei 90 %. Es werden optisch klare, transparente Schichten erhalten.

### Beispiel 3: Herstellung von alternierenden Schichten aus fluorhaltigen und nicht fluorhaltigen Amphiphilen nach der Langmuir-Blodgett Methode

Ein Glasträger wird wie in Beispiel 2 gereinigt und wie in Beispiel 2 mit 2 Monolagen des in Beispiel 1 hergestellten Copolymeren beschichtet. Danach werden nach der Methode von Langmuir und Blodgett auf einer zweiten Filmwaage zwei Monolagen eines 1 : 1 Copolymeren aus Methacrylsäurehexadecylester und Acrylsäure übertragen (Temperatur der Subphase: 30°C, Schub: 25 mN/m, Eintauchgeschwindigkeit: 20 mm/min, Austauchgeschwindigkeit: 10 mm/min). Im Anschluß daran werden wieder 2 Monolagen des fluorhaltigen und dann wieder zwei Monolagen des nicht fluorierten Polymeren übertragen, bis insgesamt 10 Monolagen übertragen sind. Die Übertragungsverhältnisse liegen bei 98 %. Man erhält auch bei Übertragung von 20 und mehr Monolagen optisch klare transparente Schichten.

### Beispiel 4: Messungen der kritischen Oberflächenspannung

Ein Siliziumplättchen (40 mm x 10 mm) wird aus einem Siliziumwafer herausgeschnitten und wie folgt gereinigt:
1. 1 Stunde Behandlung in einer heißen (60°C), frisch angesetzten Mischung aus einem Teil 30 %iger H₂O₂ und vier Teilen konz. H₂SO₄. Anschließend wird mit sauberem Wasser abgespült.
2. 30 Sekunden Eintauchen in NH₄F gepufferte HF-Lösung und anschließend wieder mit sauberem Wasser abspülen.

Nach dieser Behandlung sind die Siliziumplättchen hydrophob (Kontaktwinkel zu Wasser: 75°).

Das so gereinigte Siliziumplättchen wird wie in Beispiel 2 mit vier Monolagen des in Beispiel 1 hergestellten Polymeren beschichtet.

Auf die Oberfläche der übertragenen Schichten werden Flüssigkeitstropfen einer Reihe von n-Alkanen (C₆H₁₄ - C₁₆H₃₄) gebracht und die Kontaktwinkel der Flüssigkeitstropfen mit der Oberfläche gemessen. Aus diesen Kontaktwinkeln wird nach dem Verfahren von Zisman die kritische Oberflächenspannung bestimmt. Es ergibt sich ein Wert von 12.4 mN/m. (Zum Vergleich: Bei einer Polyethylen-Oberfläche ergibt sich bei dieser Messung ein Wert von 31 mN/m).

### Beispiel 5: Strukturierung mit Elektronenstrahlen

Ein Siliziumplättchen wird wie in Beispiel 4 beschrieben gereinigt und wie in Beispiel 3 beschrieben mit insgesamt 20 Monolagen aus dem in Beispiel 1 hergestellten Polymeren und einem 1 : 1 Copolymeren aus Methacrylsäurehexadecylester und Acrylsäure beschichtet.

Mit einem Raster-Elektronenmikroskop, mit Pattern-Generator wurde bei verschiedenen Energiedosen im Bereich von 20 bis 800 »C/cm² ein Streifenmuster in die Schicht geschrieben. Die Muster wurden durch Eintauchen für 30 Sekunden in eine Mischung aus 9 Teilen FKW 113 und einem Teil Hexafluorisopropanol entwickelt. Als Ergebnis wurde erhalten, daß ab einer Dosis von 100 »C/cm² die Strukturen gegenüber dem Entwickler vollständig resistent waren und eine gute Kantenschärfe besaßen.

## Patentansprüche

1. Schichtelement aus einem auf einem festen Träger aufgebrachten Film, bestehend aus mindestens einer monomolekularen Schicht einer amphiphilen Verbindung, dadurch gekennzeichnet, daß die Schicht ein Polymeres enthält, das (hydrophobe) Fluoralkyl-Ketten der Formel CF₃(CF₂)ₙ(CH₂)ₘ, mit n = 5 - 11 und m = 13 - 23 und m + n = 8 bis 24, und Oxiranreste besitzt.

2. Schichtelement nach Anspruch 1, dadurch gekennzeichnet, daß der Film daneben mindestens eine Schicht einer fluoralkylgruppenfreien, Alkylgruppen enthaltenden zweiten amphiphilen Verbindung aufweist.

3. Schichtelement gemäß Anspruch 2, dadurch gekennzeichnet, daß die Schichten des Films nach dem Schema A-B-A-B oder A-B-B-A-A-B alternierend angeordnet sind.

4. Verfahren zur Herstellung eines Schichtelements gemäß Anspruch 1, dadurch gekennzeichnet, daß man mindestens ein Polymeres gemäß Anspruch 1 in einem flüchtigen organischen, mit Wasser nicht mischbaren Lösemittel löst, die Lösung an der Grenzfläche Wasser/Luft spreitet, die entstehende Schicht nach Verdunsten des Lösemittels komprimiert und nach der Langmuir-Blodgett-Technik auf einen festen Schichtträger überträgt.

5. Verfahren zum Härten des auf dem Träger aufgebrachten Films gemäß Anspruch 1, dadurch gekennzeichnet, daß man energiereiche Strahlung auf den Film so lange einwirken läßt, bis die Oxiran-Ringe gespalten sind.

6. Verfahren gemäß Anspruch 5, dadurch gekennzeichnet, daß man den Film durch eine strukturierte Maske partiell vor der Strahlung schützt und man nach beendeter Bestrahlung die nicht bestrahlten Film-Anteile durch ein Lösemittel entfernt, wobei ein strukturierter Film auf dem festen Träger zurückbleibt.

7. Verfahren gemäß Anspruch 5, dadurch gekennzeichnet, daß man den Film in einem Elektronenstrahlschreibgerät durch Elektronenbeschuß strukturiert.

## Claims

1. A sandwich comprising a film deposited on a solid support, which film is composed of at least one monomolecular layer of an amphiphilic compound, wherein the layer contains a polymer which has (hydrophobic) fluoroalkyl chains of the formula CF₃(CF₂)ₙ(CH₂)ₘ, where n = 5-11 and m = 13-23 and m + n = 8 to 24, and oxirane radicals.

2. A sandwich as claimed in claim 1, wherein the film contains, in addition, at least one layer of a fluoroalkyl-group-free second amphiphilic compound containing alkyl groups.

3. A sandwich as claimed in claim 2, wherein the layers of the film are arranged in an alternating manner in accordance with the scheme A-B-A-B or A-B-B-A-A-B.

4. A process for preparing a sandwich as claimed in claim 1, which comprises dissolving at least one polymer as claimed in claim 1 in a volatile organic solvent which is immiscible with water, spreading the solution on the water/air boundary surface, compressing the layer produced after the solvent has evaporated and transferring it to a solid layer support by the Langmuir-Blodgett technique.

5. A process for curing the film as claimed in claim 1 deposited on the support, which comprises allowing high-energy radiation to act on the film until the oxirane rings have been cleaved.

6. The process as claimed in claim 5, wherein the film is partially protected from the radiation by a structured mask and the nonirradiated film portions are removed by means of a solvent after completing the irradiation, a structured film remaining behind on the solid support.

7. The process as claimed in claim 5, wherein the film is structured by electron bombardment in an electron beam writing unit.

## Revendications

1. Elément stratifié composé d'une pellicule déposée sur un support solide, laquelle pellicule se compose d'au moins une couche monomoléculaire d'un composé amphiphile, caractérisé en ce que la couche contient un polymère qui comporte des chaînes fluoroalkyle (hydrophobes) de formule CF₃(CF₂)ₙ(CH₂)ₘ, avec n = 5 - 11 et m = 13 - 23 et m + n = 8 à 24, et des radicaux oxiranne.

2. Elément stratifé selon la revendication 1, caractérisé en ce que la pellicule présente, en outre, au moins une couche d'un deuxième composé amphiphile contenant des groupes alkyle, exempt de groupes fluoroalkyle.

3. Elément stratifié selon la revendication 2, caractérisé en ce que les couches de pellicules sont disposées alternativement selon le schéma A-B-A-B ou A-B-B-A-A-B.

4. Procédé pour la préparation d'un élément stratifié selon la revendication 1, caractérisé en ce qu'on dissout au moins un polymère selon la revendication 1, dans un solvant organique volatil non miscible à l'eau, on étale la solution à l'interface eau/air, on comprime la couche formée après évaporation du solvant et on transfère sur un support de couches selon le procédé de Langmuir-Blodgett.

5. Procédé pour le durcissement du film déposé sur le support selon la revendication 1, caractérisé en ce qu'on irradie la pellicule par un rayonnement riche en énergie, jusqu'à la rupture ces cycles oxiranne.

6. Procédé selon la revendication 5, caractérisé en ce qu'on protège partiellement la pellicule par un masque structuré contre les rayonnements et après avoir terminé l'irradiation, on élimine les portions non irradiées de la pellicule à l'aide d'un solvant, en obtenant ue pellicule structurée sur le support solide.

7. Procédé selon la revendication 5, caractérisé en ce qu'on structure la pellicule dans un appareil à enregistrement par rayon d'électrons par bombardement par un faisceau d'électrons.
